Europäisches Patentamt

European Patent Office

Office européen des brevets

(11) Veröffentlichungsnummer: **0 376 296**
**A1**

## (12) EUROPÄISCHE PATENTANMELDUNG

(21) Anmeldenummer: 89124052.5

(22) Anmeldetag: 28.12.89

(51) Int. Cl.⁵: **H05K 5/00**

(30) Priorität: **30.12.88 DE 8816190 U**

(43) Veröffentlichungstag der Anmeldung:
**04.07.90 Patentblatt 90/27**

(84) Benannte Vertragsstaaten:
**AT BE CH DE FR GB IT LI LU NL**

(71) Anmelder: **Viessmann Werke GmbH & Co.**
**Postfach 10 Viessmannstrasse**
**D-3559 Allendorf (Eder)(DE)**

(72) Erfinder: **Viessmann, Hans, Dr.**

**D-3559 Battenberg/Eder(DE)**

(74) Vertreter: **Wolf, Günter, Dipl.-Ing.**
**Postfach 70 02 45 An der Mainbrücke 16**
**D-6450 Hanau 7(DE)**

(54) **Regel- und Steuergerät.**

(57) Das Regel und Steuergerät ist insbesondere für die Regelung und Steuerung von Heizungsanlagen bestimmt und besteht aus einem mit Sockel (2) versehenen Gehäuse (1), in dem mehrere Bedienungs-und Regelmodule angeordnet sind und das mit mindestens einer die mindestens einen Teil der Ablese-, Anzeige- und Informationsfelder aufweisende Frontfläche (3) abdeckenden Verschlußklappe (4) versehen ist.

Um ein derartiges Gerät bei aufrechterhaltener guter Ables- und Bedienbarkeit sowohl vertikal als auch horizontal am Kesselgehäuse installieren zu können, ist dieses derart ausgebildet, daß das Gehäuse (1) im Bereich seiner Seitenflanken (5) und der Frontfläche (3) mit Verschlußklappen-Gelenkaufnahmen (6) versehen und an diesen die Verschlußklappe (4) lösbar und entweder oben oder unten parallel zum oberen oder unteren Längsrand (5′, 5″) der Frontfläche (3) angelenkt ist.

Ferner sind das oder die Informationsfelder (7) der Frontfläche stellungsveränderlich an oder auf der Frontfläche (3) angeordnet.

FIG.2

## Regel- und Steuergerät

Die Erfindung betrifft ein Regel- und Steuergerät, insbesondere für die Regelung und Steuerung von Heizungsanlagen gemäß Oberbegriff des Hauptanspruches.

Derartige Regel- und Steuergeräte sind hinlänglich bekannt und in Benutzung und zwar insbesondere zur Regelung und Steuerung von Heizungsanlagen, wobei derartige (siehe bspw. DE-U-8708646.8) Geräte in der Regel unmittelbar am Gehäuse des betreffenden Heizungskessels angebracht werden. Diese Anbringung erfolgt normalerweise auf der Oberfläche der Heizkesselummantelung, es sind aber auch Anbringungen an vertikalen Wänden möglich und insbesondere dann notwendig, wenn es sich um vertikal aufgestellte Heizkessel handelt, deren Höhe in der Regel keine Anbringung auf dem Heizkessel zuläßt und zwar insbesondere dann, wenn die Oberfläche des Heizkesselgehäuses mit einem oben angeordneten Sturzbrenner und den zugehörigen Einrichtungen besetzt ist. Da die Regel- und Steuererfordernisse für Heizungsanlagen immer größer und anspruchsvoller geworden sind, schlägt sich dies zwangsläufig in den Abmessungen der Regel- und Steuergeräte nieder, was dazu führen kann, daß ein derartiges Gerät zwar ohne weiteres oben auf einem Kessel aufgesetzt werden kann, dies aber an einer vertikalen Wand aufgrund der Gehäuseabmessungen nicht mehr ohne weiteres praktikabel ist. Abgesehen von den unterschiedlichen Kesseltypen und deren Anbringungsmöglichkeiten für solche Regel- und Steuergeräte muß noch in Betracht gezogen werden, daß die Ables- und Bedienbarkeit solcher Geräte auf jeden Fall bequem gewährleistet sein muß. Der Hersteller derartiger Geräte steht also vor dem Problem, allen Anordnungs- und Anbringungserfordernissen Rechnung tragen zu müssen, was bei den bisherigen Geräten dieser Art noch nicht gelungen ist, d.h., die Geräte waren bisher ausschließlich für eine Anbringungsart, d.h. auf oder seitlich am Kesselgehäuse bestimmt, und man konnte bspw. ein horizontal anzuordnendes Gerät nicht einfach senkrecht orientiert anbringen und zwar insbesondere deshalb nicht, weil dann die Verschlußklappe nach der ungeeigneten Seite aufschlägt und/oder die Informationsfelder mit ihren Beschriftungen für den Betrachter auf dem Kopf stehen würden.

Der Erfindung liegt demgemäß die Aufgabe zugrunde, ein Regel-und Steuergerät der gattungsgemäßen Art dahingehend zu verbessern, daß es sowohl vertikal als auch horizontal angeordnet werden kann und zwar mit der Maßgabe, dabei trotzdem eine bequeme Bedien- und Ablesbarkeit aufrechtzuerhalten.

Diese Aufgabe ist mit einem Regel- und Steuergerät der eingangs genannten Art nach der Erfindung durch die im Kennzeichen des Hauptanspruches angeführten Merkmale gelöst. Vorteilhafte Weiterbildungen und praktische Ausführungsformen ergeben sich nach den Unteransprüchen.

Bei einer solchen Ausbildung ist der Hersteller in die Lage versetzt, für die unterschiedlichsten Heizkesseltypen aber auch unterschiedliche Anordnungen lediglich ein Regel- und Steuergerät herstellen zu können und nicht konstruktiv voneinander abweichende Geräte fertigen zu müssen. Der dafür erforderliche, im Vergleich zu "Normalgeräten" etwas größere Fertigungsaufwand steht aber in keinem Verhältnis zum Aufwand, der sich bei konstruktiv unterschiedlich gestalteten Geräten ergeben würde. Da der Gerätesockel in jedem Fall als Befestigungselement, ob nun in horizontaler oder in vertikaler Anbringung des Gerätes, dienen muß, sind die Verschlußklappe und die Frontfläche die wesentlichen Teile, mit denen unterschiedlichen Anbringungsarten Rechnung getragen werden kann. Dies wird in einfacher Weise nach der Erfindung dadurch erreicht, daß das Gehäuse im Bereich sei ner Seitenflanken mit Verschlußklappen-Gelenkaufnahmen versehen und an diesen die Verschlußklappe lösbar und entweder oben oder unten parallel zum oberen oder unteren Längsrand der Frontfläche angelenkt ist. Ferner ist es wesentlich, daß das oder die Informationsfeld(er) der Frontfläche stellungsveränderlich am oder auf der Frontfläche angeordnet sind. Diesbezüglich besteht die einfachste und praktische Verwirklichungsform darin, daß man die Informationsfelder bspw. in Form von entsprechend beschrifteten und aufklebbaren Folien bzw. Folienstreifen od. dgl. ausbildet, die je nach vorgesehener Anbringungsart des Gerätes in der dafür erforderlichen und richtigen Ablesestellung aufgebracht werden. Eine bspw. die gesamte Frontfläche abdeckende und sämtliche Informationsfelder enthaltende Folie wäre für diesen Zweck dann nicht geeignet - was in der Regel der Fall ist - wenn die zu den Informationsfeldern gehörenden Bedienungs- und Anzeigeelemente keine symmetrische Anordnung auf der Frontfläche haben. Abgesehen von einer solchen symmetrischen Anordnung kommt noch hinzu, daß die Bedienungs- und Anzeigeelemente unterschiedliche Formen und Größen aufweisen. Bezüglich der Informationsfelder wäre es natürlich auch möglich, die Frontfläche mit auswechselbaren, in entsprechenden Frontflächenausnehmungen sitzenden Flächenteilen auszustatten, die dann bei anderer Positionierung des ganzen Gerätes ausgetauscht oder verstellt werden können. Dies wäre jedoch mit einem beträchtlichen Aufwand verbunden, weshalb die Stellungsveränderlichkeit der Informationsfelder bevorzugt durch leicht auswechselbare Folienstreifen bzw. Folienabschnitte verwirklicht wird.

Die lösbare Zuordnung schließt natürlich auch die vorteilhafte Möglichkeit mit ein, die Verschlußklappe, wenn diese bspw. als Halter für zusätzliche Bedienteile ausgenutzt wird, unter Verwendung eines besonderen Sockels, was noch näher erläutert wird, auch entfernt vom eigentlichen Gerätegehäuse anzuordnen, wenn dies die Installationsverhältnisse verlangen sollten.

Was den Sockel des Gehäuses betrifft, so kann dieser auch in Form eines das Gehäuse zum Teil u-förmig umfassenden Halters ausgebildet werden, wobei das Gehäuse in einem solchen Sockel in geeigneter Weise fixiert wird. Bei einer solchen Sockelausbildung hat man ohne weiteres die Möglichkeit, für eine Horizontalanordnung des Gerätes den einen Sockelschenkel zu benutzen, während für eine Vertikalanordnung des Gerätes der andere Sockelschenkel zur Befestigung benutzt wird. In diesem Fall bedarf es nicht einmal einer Umstellung der Informationsfelder.

Das erfindungsgemäße Regel- und Steuergerät wird nachfolgend anhand der zeichnerischen Darstellung von Ausführungsbeispielen näher erläutert.

Es zeigt schematisch

Fig. 1 eine Vorderansicht des Gerätes;

Fig. 2 eine Vorderansicht des Gerätes mit geöffneter Verschlußklappe;

Fig. 3-8 unterschiedliche Anordnungen des Gerätes an horizontalen und vertikalen Anbringungsflächen;

Fig. 9 perspektivisch eine besondere Ausführungsform des Gerätes;

Fig. 10,11 ebenfalls perspektivisch eine weitere besondere Ausführungsform und

Fig. 12,13 in Seitenansicht vertikale und horizontale Anordnungen des Gerätes in Verbindung mit einer besonderen Sockelgestaltung.

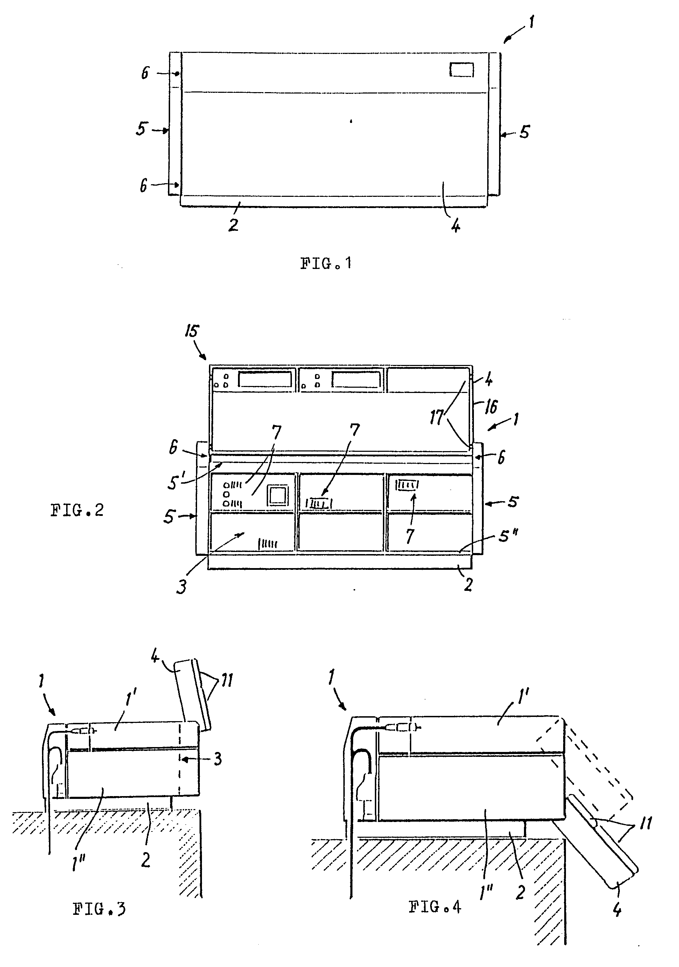

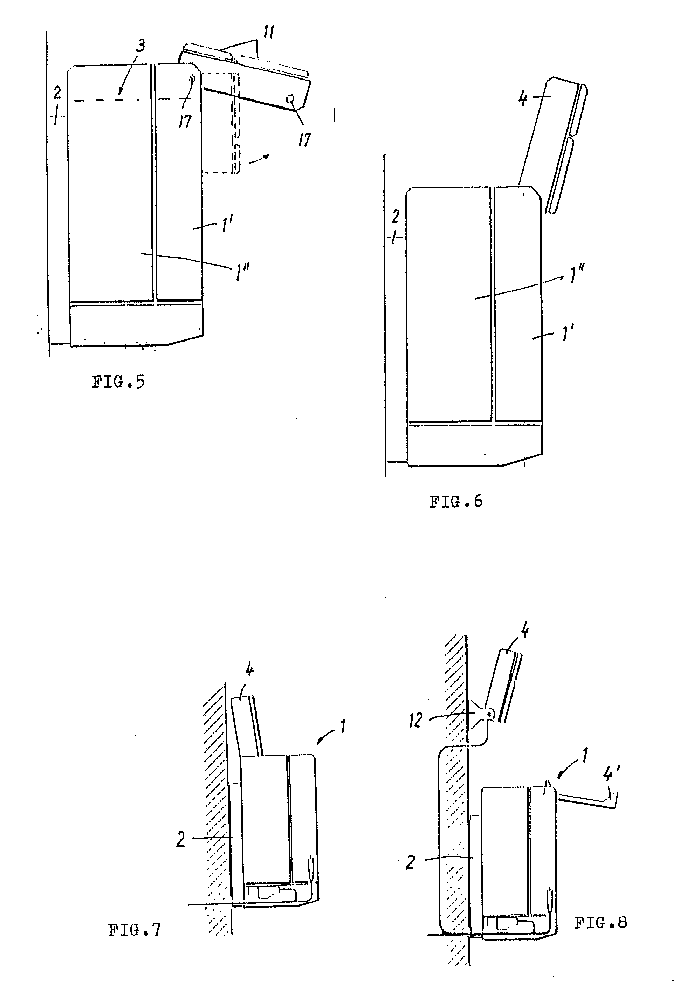

Wie aus Fig. 1, 2 ersichtlich, besteht das Regel- und Steuergerät aus einem mit Sockel 2 versehenen Gehäuse 1, in dem mehrere Bedienungs- und Regelmodule angeordnet sind, und das mit mindestens einer die mindestens einen Teil der Ablese-, Anzeige- und Informationsfelder aufweisende Frontfläche 3 abdeckenden Verschlußklappe 4 versehen ist. Die Anordnung mehrerer Bedienungs-und Regelmodule bedarf im vorliegenden Zusammenhang keiner besonderen Erläuterung, zumal die Unterbringung derartiger Module in solchen Geräten hinlänglich bekannt ist. Wie aus Fig. 2 ersichtlich, bilden die vorderen Abschlußflächen solcher Module, wenn sie im Gerät eingesetzt bzw. eingeschoben sind, die mit 3 bezeichnete Frontfläche, die zugehörig zu entsprechenden Bedienungs- bzw. Anzeigeelementen entsprechende Informationsfelder 7 bzw. entsprechende Beschriftungsfelder (Zahlen, Buchstaben, Symbole) aufweisen. Sofern die Verschlußklappe 4 entsprechend dimensioniert und mit geeigneten Halteelementen versehen ist, können in der Verschlußklappe 4 selbst ebenfalls entsprechend flache zusätzliche Bedienungseinheiten untergebracht sein. Wesentlich ist nun, daß das Gehäuse 1 im Bereich seiner Seitenflanken 5 und der Frontfläche mit Verschlußklappen-Gelenkaufnahmen 6 versehen und an diesen die Verschlußklappe 4 lösbar und entweder oben oder unten parallel zum oberen oder unteren Längsrand 5', 5" der Frontfläche 3 anlenkbar ist. In den Fig. 1 bis 8 ist diese Anlenkbarkeit im einzelnen nicht verdeutlicht, zumal diese Anlenkbarkeit auf unterschiedliche Weise verwirklicht werden kann. Abgesehen von dieser Lösbarkeit der Verschlußklappe und deren Anlenkbarkeit sowohl unten als auch oben ist ferner wesentlich, daß die Informationsfelder 7 der Frontfläche stellungsveränderlich an oder auf der Frontfläche 3 angeordnet sind. Wie dargestellt und wie bereits vorerwähnt, ist diese Stellungsveränderlichkeit am zweckmäßigsten und bevorzugt mit aufklebbaren und entsprechend beschrifteten Folienstreifen verwirklicht.

Die sich dadurch ergebenden unterschiedlichen Anbringungsmöglichkeiten des Gerätes an horizontal oder vertikal orientierten Anbringungsflächen sind in den Fig. 3 bis 8 verdeutlicht. Die in den Fig. 3 bis 8 dargestellten Anordnungen sprechen dabei für sich selbst, wobei die Zuordnung der Verschlußklappe 4 am Frontflächenbereich des Gerätes zu diesem auf unterschiedlichste Weise je nach Grundposition des Gerätes er folgen kann. Gemäß Fig. 8 ist es dabei auch möglich, die Verschlußklappe 4 auch als separates Element gemäß Fig. 8 separat und exponiert über dem eigentlichen Gerät mit Hilfe eines besonderen Sockels 12 anzuordnen. Da am Gerät Verschlußklappen-Gelenkaufnahmen 6 per se vorhanden sind, besteht auch durchaus die Möglichkeit, bei der Anordnungsform gemäß fig. 8 das Gerät mit einer einfachen, bspw. transparenten Verschlußklappe 4' auszustatten, für die natürlich Voraussetzung ist, daß sie entsprechende Gelenkelemente aufweist, die in die Gelenkaufnahmen 6 passen.

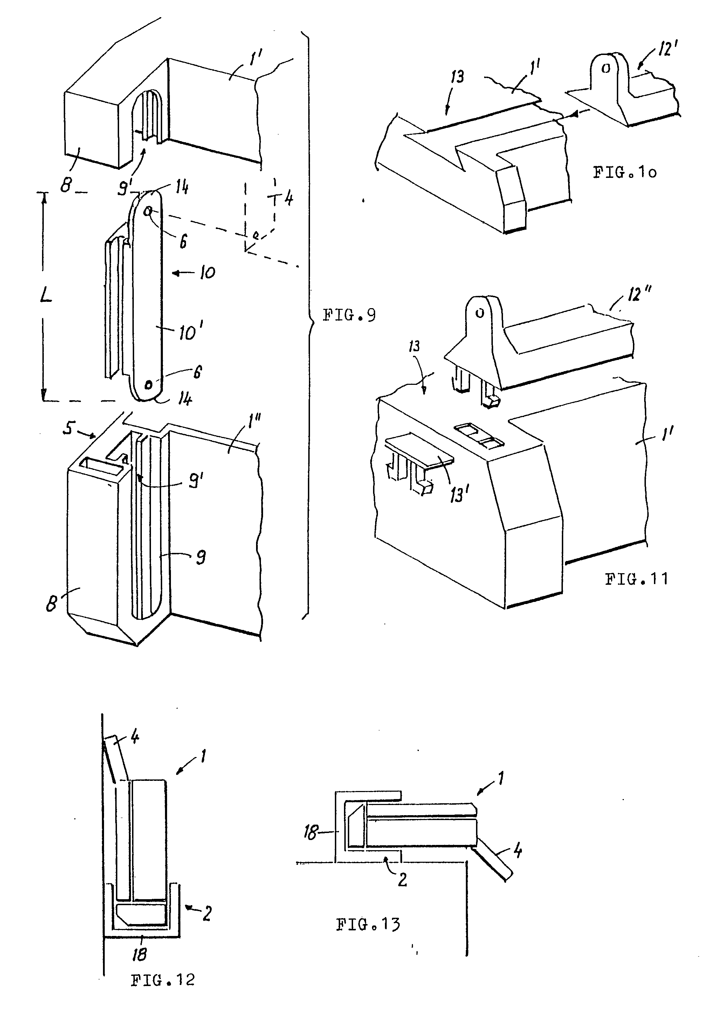

In praktischer aber auch nur beispielsweiser Ausführungsform ist das Gerät gemäß Fig. 9 derart ausgebildet, daß die in Form von die Frontfläche überragenden Seitenwandfortsätzen 8 ausgebildeten Seitenflanken 5 mit Einsteckkanälen 9 und die Verschlußklappe 4 mit in die Einsteckkanäle 9 passenden, mit der Verschlußklappe 4 gelenkig verbundenen Steckzapfen 10 versehen sind. Sofern das Gehäuse 1, was in der Regel der Fall ist, aus einem Oberteil 1' und einem Unterteil 1" besteht, so sind diese Teile, wie dargestellt, jeweils mit zueinander fluchtenden und sich entsprechend innenprofilierten Einsteckkanalteilen 9′ in ihren Seitenwandfortsätzen 8 versehen. Die Steckzapfen 10 sind dabei, entsprechend profiliert, als mit ihrem einen oder anderen Ende 14 in das untere und obere Kanalteil 9′ einführbare Schieber 10′ ausgebildet, deren Länge L der Gesamtlänge beider Kanalteile 9′ entspricht. Sowohl die Steckzapfen 10 als auch die Seitenflanken 16 der Verschlußklappe 4 weisen dabei entsprechende Elemente für ihre gelenkige Verbindung auf. Da die Steckzapfen 10 ohne weiteres umgesteckt werden können, ist es möglich, die Öffnung am Schieber 10′ entweder oben oder unten anzuordnen, je nachdem, welche Aufklapprichtung man für die Verschlußklappe 4 wünscht. Zweckmäßig wird dabei auch die Verschlußklappe 4 in beiden Endbereichen 15 ihrer Seitenflanken 16 (siehe Fig. 2) mit Gelenkaufnahmen 17 versehen, wodurch auch die Verschlußklappe in unterschiedlicher Weise, wie bspw. aus den Fig. 3 und 5 ersichtlich, im Frontflächenbereich des Gerätes angelenkt werden kann. Dies ist insbesondere dann von Interesse, wenn die Verschlußklappe als Träger für zusätzliche, in diesem einsetzbare Bedienungseinheiten 11 ausgebildet ist.

Der bereits angesprochene Sockel 12 für eine separate Anbringung der Verschlußklappe 4 kann in Weiterbildung auch im Sinne der Fig. 10 ausgebildet werden, wobei ggf. sogar die Möglichkeit besteht, wie dargestellt, die Oberfläche des Gerätegehäuses 1 mit einer entsprechenden Nut auszustatten, in die der Sockel 12′ eingesetzt werden kann.

Abgesehen davon besteht ferner die Möglichkeit, den Sockel 12″ für die Verschlußklappe 4 verrastbar auszubilden. Eine solche Verrastbarkeit kann bei entsprechender Gestaltung der Schieber 10 auch mit diesen vorgesehen werden. Sofern für die Sockelverrastung besondere Öffnungen, wie in Fig. 11 dargestellt, vorgesehen sind, werden für diese Öffnungen Schnappverschlüsse 13′ vorgesehen, die die Öffnungen verschließen, wenn die Verschlußklappe mit dem Sockel 12′ im Sinne der Fig. 8 separat angeordnet wird. Da die Teile aus Kunststoff bestehen, ergeben sich in diesem Zusammenhang bei Wandbefestigung des Sockels 12′ keine Schwierigkeiten, die Verrastungszapfen zu entfernen.

Zu erläutern ist nun noch die besondere Ausführungsform des Gerätesockels 2 gemäß der Fig. 12, 13. Wie ersichtlich, ist hierbei der Sockel 2 des Gehäuses in Form eines das Gehäuse 1 zum Teil u-förmig umfassenden Halters 18 ausgebildet. Aufgrund dieser Ausbildung kann der Halter 18 mit seinem einen Schenkel, wie aus Fig. 12 ersichtlich, an einer vertikalen Wand befestigt und darin das Gerät in vertikaler Anordnung angeordnet werden.

Andererseits ist aber auch mit dem gleichen Sockel eine Horizontalanordnung des Gerätes gemäß Fig. 13 möglich, wenn zur Befestigung der andere Sockelschenkel benutzt wird. Bei dieser Sockelausbildung und Anordnung der Geräte ist es nicht notwendig, die Informationsfelder umzustellen, da in beiden Fällen sowohl bei vertikaler als auch horizontaler Orientierung des Gerätes die Informationsfelder der Frontfläche lesbar bleiben. Die Verschlußklappen 4 können in beiden Anordnungsfällen selbstverständlich auch, wie vorbeschrieben, in anderer Stellung an den Seitenflanken 5 des Gehäuses 1 angelenkt werden.

## Ansprüche

1. Regel- und Steuergerät, insbesondere für die Regelung und Steuerung von Heizungsanlagen, bestehend aus einem mit Sockel (2) versehenen Gehäuse (1), in dem mehrere Bedienungs- und Regelmodule angeordnet sind und das mit mindestens einer die mindestens einen Teil der Ablese-, Anzeige- und Informationsfelder aufweisende Frontfläche (3) abdeckenden Verschlußklappe (4) versehen ist,
**dadurch gekennzeichnet,**
daß das Gehäuse (1) im Bereich seiner Seitenflanken (5) und der Frontfläche (3) mit Verschlußklappen-Gelenkaufnahmen (6) versehen und an diesen die Verschlußklappe (4) lösbar und entweder oben oder unten parallel zum oberen oder unteren Längsrand (5′, 5″) der Frontfläche (3) angelenkt ist, und daß ferner das oder die Informationsfelder (7) der Frontfläche stellungsveränderlich an oder auf der Frontfläche (3) angeordnet sind.

2. Gerät nach Anspruch 1,
**dadurch gekennzeichnet,**
daß die in Form von die Frontfläche (3) überragenden Seitenwandfortsätzen (8) ausgebildeten Seitenflanken (5) mit Einsteckkanälen (9) und die Verschlußklappe (4) mit in die Einsteckkanäle (9) passenden, mit der Verschlußklappe (4) gelenkig verbundene Steckzapfen (10) versehen ist.

3. Gerät nach Anspruch 1 oder 2,
**dadurch gekennzeichnet,**
daß die Verschlußklappe (4) als Träger für zusätzliche, in diesen einsetzbare Bedienungseinheiten (11) ausgebildet ist.

4. Gerät, insbesondere nach Anspruch 3,
**dadurch gekennzeichnet,**
daß die Verschlußklappe (4) mit einem Sockel (12) gelenkig verbindbar ausgebildet und dieser frontflächenseitig an oder in der Oberfläche (13) des Gerätegehäuses (1) befestigbar ausgebildet ist.

5. Gerät nach Anspruch 2 oder 3,
**dadurch gekennzeichnet,**
daß das Gehäuse (1) aus einem Oberteil (1′) und einem Unterteil (1″) gebildet ist, die jeweils zueinander fluchtende und sich entsprechend innenprofilierte Einsteckkanalteile (9′) in ihren Seitenwandfortsätzen (8) aufweisen, und daß die Steckzapfen (10), entsprechend profiliert, als mit ihrem einen oder anderen Ende (14) in das untere und obere Kanalteil (9′) einführbare Schieber (10′) ausgebildet sind, deren Länge (L) der Gesamtlänge beider Kanalteile (9′) entspricht.

6. Gerät nach einem der Ansprüche 1 bis 5,
**dadurch gekennzeichnet,**
daß die Verschlußklappe (4) in beiden Endbereichen (15) ihrer Seitenflanken (16) mit Gelenkaufnahmen (17) versehen ist.

7. Gerät, insbesondere nach einem der Ansprüche 1 bis 6,
**dadurch gekennzeichnet,**
daß der Sockel (2) des Gehäuses (1) in Form eines das Gehäuse (1) zum Teil u-förmig umfassenden Halters (18) ausgebildet ist.

FIG.1

FIG.2

FIG.3

FIG.4

FIG.5

FIG.6

FIG.7

FIG.8

FIG.9

FIG.10

FIG.11

FIG.12

FIG.13

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y,D | DE-U-8708646 (VIESMANN WERKE GMBH) <br> * Seite 11; Figur 6 * <br> --- | 1-3, 6 | H05K5/00 |
| Y | DE-A-3344071 (PIONEER ELECTRONIC CORP.) <br> * Seite 8, Zeile 2 - Seite 9, Zeile 24; Figuren 5-7 * <br> --- | 1-3, 6 | |
| A | US-A-4168870 (HILL) <br> * Spalte 2, Zeilen 38 - 51 * <br> ----- | 1 | |

**RECHERCHIERTE SACHGEBIETE (Int. Cl.5)**

H05K

Der vorliegende Recherchenbericht wurde für alle Patentansprüche erstellt

| Recherchenort | Abschlußdatum der Recherche | Prüfer |
|---|---|---|
| DEN HAAG | 28 MAERZ 1990 | TOUSSAINT F.M.A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

.....................................................

& : Mitglied der gleichen Patentfamilie, übereinstimmendes Dokument

EPO FORM 1503 03.82 (P0403)